# EUROPÄISCHE PATENTSCHRIFT

(11) **EP 3 332 431 B1**
(45) Veröffentlichungstag und Bekanntmachung des Hinweises auf die Patenterteilung: **23.12.2020**
(21) Anmeldenummer: 16729270.5
(22) Anmeldetag: 16.06.2016
(51) Int. Cl.: H01L 41/047, H01L 41/293

(54) **HERSTELLUNGSVERFAHREN ZUM HERSTELLEN EINES ELEKTROMECHANISCHEN AKTORS UND ELEKTROMECHANISCHER AKTOR**
PRODUCTION METHOD FOR PRODUCING AN ELECTROMECHANICAL ACTUATOR AND ELECTROMECHANICAL ACTUATOR
PROCÉDÉ DE FABRICATION D'UN ACTIONNEUR ÉLECTROMÉCANIQUE ET ACTIONNEUR ÉLECTROMÉCANIQUE

(30) Priorität: 03.08.2015 DE 102015214778
(43) Veröffentlichungstag der Anmeldung: 13.06.2018
(73) Patentinhaber: Vitesco Technologies GmbH, 30165 Hannover (DE)
(72) Erfinder: HAUBOLD, Jörg, 09212 Limbach-Oberfrohna (DE); HEINZE, Thomas, 09212 Limbach-Oberfrohna (DE); KREISSIG, Udo, 09114 Chemnitz (DE); LENK, Andreas, 01728 Bannewitz / OT Possendorf (DE); MEINER, Andreas, 09235 Burkhardtsdorf (DE)
(74) Vertreter: Waldmann, Georg Alexander
(86) Internationale Anmeldenummer: PCT/EP2016/063841
(87) Internationale Veröffentlichungsnummer: WO 2017/021045

(56) Entgegenhaltungen:
- EP-A1- 1 675 190
- DE-A1-102005 034 904
- DE-A1-102008 027 115
- DE-A1-102012 207 598
- DE-B3-102006 003 070

## Beschreibung

Die Erfindung betrifft ein Herstellungsverfahren zum Herstellen eines elektromechanischen Aktors.

Elektromechanische Aktoren werden häufig, beispielsweise in Form von Piezostapeln, als Betätigungselemente verwendet, z.B. in Einspritzventilen der verschiedensten Motortypen für Kraftfahrzeuge.

Solche elektromechanischen Aktoren weisen zumeist eine Mehrzahl von auf Anlegen eines elektrischen Feldes reagierenden Werkstoffschichten und eine Mehrzahl von Elektrodenschichten auf, die alternierend entlang einer Längsachse aufeinandergestapelt angeordnet sind. Zumeist wird ein solcher Stapel an zwei sich gegenüberliegenden Umfangsseiten elektrisch kontaktiert, um die Elektrodenschichten in dem Stapel ansteuern zu können, so dass sich ein elektrisches Feld innerhalb des Stapels ausbildet, auf das die Werkstoffschichten dann durch Ausdehnung reagieren.

Um das elektrische Feld ausbilden zu können, werden zwei benachbarte Elektrodenschichten mit unterschiedlichen Potentialen angesteuert, d.h. die Kontaktierung nach außen endet an unterschiedlichen Kontaktierungsanschlüssen. Um diese unterschiedliche Kontaktierung realisieren zu können, ist es beispielsweise bekannt, nur jede zweite Elektrodenschicht bis an die jeweilige Umfangsseite heranzuführen, während sich die jeweils andere Elektrodenschicht nicht bis zu dieser jeweiligen Umfangsseite hin erstreckt.

Es ist jedoch auch bekannt, alle Elektrodenschichten allseitig bis an die Umfangsseiten des Stapels heranzuführen, was große Vorteile hinsichtlich der Betätigung, Raumbeanspruchung und dem gesamten Betriebsverhalten des elektromechanischen Aktors hat. Hier ist jedoch die elektrische Kontaktierung der jeweiligen Elektrodenschichten schwieriger, da eine Isolierung jeder zweiten Elektrodenschicht von einer Außenkontaktierung schwieriger umzusetzen ist. Beispielsweise wird bei solchen Stapelaufbauten eine Isolationsschicht verwendet, die dann selektiv entfernt wird, um jede zweite Elektrodenschicht gezielt zu kontaktieren.

In DE 10 2006 003 070 B3 ist beispielsweise beschrieben, dass zur Kontaktierung der Elektrodenschichten in einem entsprechenden Stapel die Isolationsschicht an vorbestimmten Positionen entfernt wird.

DE 10 2012 207 598 A1 beschreibt ein Verfahren zum elektrischen Kontaktieren eines elektronischen Bauelements als Stapel, das aus einer Mehrzahl von auf Anlegen eines elektrischen Feldes reagierenden Werkstoffschichten und einer Mehrzahl von Elektrodenschichten gebildet ist, wobei jede Werkstoffschicht zwischen zwei der Elektrodenschichten angeordnet ist. In dem Verfahren wird auf zumindest einem Stapelumfangsbereich des Stapels eine Isolationsstruktur erzeugt, wodurch jede zweite Elektrodenschicht des zumindest einen Stapelumfangsbereichs zur elektrischen Kontaktierung frei gelegt ist. Ferner wird auf den zumindest einen, mit der Isolationsstruktur versehenen Stapelumfangsbereich eine Kontaktierungsstruktur aufgebracht. Das Verfahren zeichnet sich dadurch aus, dass vor dem Schritt des Erzeugens der Kontaktierungsstruktur mittels eines materialabtragenden Verfahrens die Werkstoffschichten partiell derart abgetragen werden, dass die Elektrodenschichten oberflächennah freigelegt werden.

Dabei bleibt jedoch offen, wie es gelingt, die Elektrodenschichten zuverlässig freizulegen, ohne dabei das Material der auf das elektrische Feld reagierenden Werkstoffschichten zu beschädigen.

Aufgabe der Erfindung ist es daher, ein in dieser Hinsicht verbessertes Herstellungsverfahren vorzuschlagen.

Diese Aufgabe wird gelöst mit einem Herstellungsverfahren mit der Merkmalskombination des Anspruches 1.

Vorteilhafte Ausgestaltungen der Erfindung sind Gegenstand der abhängigen Ansprüche.

Bei einem Herstellungsverfahren zum Herstellen eines elektromechanischen Aktors wird zunächst ein als Stapel ausgebildetes elektrisches Bauelement bereitgestellt, das aus einer Mehrzahl von auf Anlegen eines elektrischen Feldes reagierenden Werkstoffschichten und aus einer Mehrzahl von Elektrodenschichten gebildet ist, wobei jede Elektrodenschicht zwischen zwei Werkstoffschichten angeordnet ist. Dann wird auf wenigstens einen Umfangsbereich des Stapels eine Isolationsschicht aufgebracht, und zwar derart, dass an dem Umfangsbereich die Elektrodenschichten und die Werkstoffschichten von der Isolationsschicht bedeckt sind. Darauf folgend wird wenigstens eine der Elektrodenschichten an dem Umfangsbereich des Stapels freigelegt, und zwar durch lokales Abtragen eines der Elektrodenschicht benachbarten Isolationsschichtbereiches und von der Elektrodenschicht entlang der Längsachse des Stapels benachbarten Werkstoffschichtbereichen. Ein Isolationsschichtmaterial, ein Werkstoffschichtmaterial und ein Elektrodenschichtmaterial werden so ausgewählt, und Abtragungsparameter einer Abtragungsvorrichtung zum Abtragen des Isolationsschichtbereiches und der Werkstoffschichtbereiche so eingestellt, dass eine erste Abtragungsrate des Isolationsschichtmaterials wesentlich größer ist als eine zweite Abtragungsrate des Werkstoffschichtmaterials, und dass die zweite Abtragungsrate des Werkstoffschichtmaterials wesentlich größer ist als eine dritte Abtragungsrate des Elektrodenschichtmaterials.

Bei dem Herstellungsverfahren werden demgemäß die Parameter, die eine Auswirkung auf die Abtragungsrate des jeweiligen abzutragenden Materials haben, so eingestellt, dass das Isolationsschichtmaterial im Bereich der freizulegenden Elektrodenschicht vollständig abgetragen wird, und dass Teilbereiche der Werkstoffschichten, die der freizulegenden Elektrodenschicht direkt benachbart sind, ebenfalls abgetragen werden. Dabei sind die Abtragungsraten der unterschiedlichen Materialien vorzugsweise so eingestellt, dass die Isolationsschicht vollständig, die Werkstoffschichten nur teilweise und die Elektrodenschicht gar nicht abgetragen werden.

Dadurch kann sichergestellt werden, dass die jeweils freizulegenden Elektrodenschicht vollständig freigelegt ist, so dass eine gute Kontaktierung möglich ist, d.h. sowohl auf der Seite des Umfangsbereiches des Stapels, als auch wenigstens teilweise an Stirnseiten der Elektrodenschicht, die in Kontakt stehen mit den benachbarten Werkstoffschichten.

Die Parameter, die einen Einfluss auf die jeweilige Abtragungsrate haben, sind das Material, das abzutragen ist, sowie die Abtragungsparameter der Abtragungsvorrichtung, die verwendet wird, um das Abtragen durchzuführen.

Vorzugsweise wird das Isolationsschichtmaterial, das Werkstoffschichtmaterial und das Elektrodenschichtmaterial so ausgewählt und werden die Abtragungsparameter der Abtragungsvorrichtung so eingestellt, dass der Isolationsschichtbereich senkrecht zu der Längsachse des Stapels vollständig abgetragen wird und/oder dass die Werkstoffschichtbereiche senkrecht zu der Längsachse des Stapels zwischen 10% und 20% der sich senkrecht zu der Längsachse des Stapels erstreckenden Breite der Werkstoffschichten abgetragen werden. Besonders bevorzugt werden die oben genannten Parameter so eingestellt, dass die Elektrodenschicht senkrecht zu der Längsachse des Stapels zwischen 0% und 1% der sich senkrecht zu der Längsachse des Stapels erstreckenden Breite der Elektrodenschicht abgetragen wird.

Das heißt, es wird die Abtragung so durchgeführt, dass die Isolationsschicht vollständig entfernt ist, die an die Elektrodenschicht angrenzenden Werkstoffschichtbereiche ganz geringfügig abgetragen werden, um so auch die an die Werkstoffschichten angrenzenden Stirnseiten der Elektrodenschicht zumindest im Bereich des Umfangsbereiches freizulegen, und die Elektrodenschicht nach Möglichkeit gar nicht abgetragen wird.

Dadurch wird vorteilhaft erzielt, dass die Elektrodenschicht aus den Werkstoffschichten, die der Elektrodenschicht benachbart sind, hervorsteht, so dass eine gute Kontaktierung von außen ermöglicht wird.

Besonders vorteilhaft werden die oben genannten Parameter so eingestellt, dass die erste Abtragungsrate wenigstens fünf Mal größer ist als die zweite Abtragungsrate. Vorteilhaft werden die Parameter so eingestellt, dass die zweite Abtragungsrate wenigstens fünf Mal größer ist als die dritte Abtragungsrate.

Insgesamt wird demgemäß erzielt, dass beim Freilegen der Elektrodenschicht unter der Isolationsschicht eine doppelte Selektivität erzielt wird, d.h. dass die Abtragungsrate für die Isolationsschicht wesentlich höher ist als die Abtragungsrate für die Werkstoffschichten, und das gleichzeitig die Abtragungsrate für die Werkstoffschichten wesentlich höher ist als die Abtragungsrate für die Elektrodenschicht.

Eine besonders hohe Selektivität kann erzielt werden, wenn die Abtragungsraten sich jeweils mindestens um den Faktor fünf unterscheiden.

Vorteilhaft wird als Isolationsschichtmaterial ein Polyimid, als Werkstoffschichtmaterial eine Piezokeramik und als Elektrodenschichtmaterial mit Palladium versetztes Silber ausgewählt.

Polyimid als das Material der Isolationsschicht hat den Vorteil, dass es ein Kunststoffisolator ist, der Einsatztemperaturen überstehen kann, unter denen normalerweise das elektrische Bauelement betrieben wird.

Vorteilhaft wird als Abtragungsvorrichtung ein Laser, insbesondere eine Pikosekunden-Laser mit einer Pulslänge zwischen 1 ps und 15 ps, verwendet. Durch die Verwendung eines solchen Ultrakurzpulslasers ist es möglich, die Laserparameter geeignet einzustellen, um eine Selektivität zwischen den Werkstoffschichten, den Elektrodenschichten und der Isolationsschicht zu erreichen.

Die Verwendung eines Pikosekunden-Lasers ist vorteilhaft, da dadurch wegen der ultrakurzen Pulse eine hohe Leistungsdichte erzielt werden kann, wobei jedoch gleichzeitig die Leistungsdichte vorteilhaft nicht ausreicht, um auch das Material der Elektrodenschicht abzutragen.

Vorzugsweise wird eine Wellenlänge des Lasers so eingestellt, dass durch Beaufschlagen der Isolationsschicht mit einer Laserstrahlung des Lasers chemische Bindungen in der Isolationsschicht gelöst werden. Beispielsweise wird bei einer Verwendung von Polyimid als Isolatonsschichtmaterial eine Wellenlänge von 330 nm bis 345 nm, insbesondere 343 nm, eingestellt. Dadurch, dass sich die chemischen Bindungen in dem Material der Isolationsschicht lösen, entstehen kurzkettige Bruchstücke, die so klein sind, dass sie als Gas oder kleinste Partikel durch eine Plasmabildung von der Oberfläche des Stapels geschleudert werden. Das so entfernte Material der Isolationsschicht lagert sich beispielsweise als Schmauch ab und kann später einfach durch einen Waschprozess entfernt werden.

Vorzugsweise wird eine Pulsenergie von Laserpulsen des Lasers in einem Bereich zwischen 1,2 µJ und 1,6 µJ eingestellt. Weiter vorteilhaft wird eine Fokusfläche der Laserstrahlung des Lasers in einem Bereich von 20 µm bis 60 µm eingestellt.

Durch diese vorteilhaften genannten Werte kann eine Leistungsdichte des verwendeten Lasers eingestellt werden, die in der oben genannten Selektivität resultiert.

Bevorzugt wird die Leistungsdichte des Lasers so eingestellt, dass das Material der Elektrodenschichten nicht oxidiert.

Vorzugsweise wird eine Laserstrahlung des Lasers, insbesondere mit Hilfe eines Galvanoscanners, der beispielsweise bewegliche Spiegel aufweist, über eine Isolationsschichtoberfläche geführt, sodass das Abtragen der Isolationsschicht vorzugsweise Bahn für Bahn erfolgt. Das bedeutet, die Laserstrahlung wird scannend über die Isolationsschichtoberfläche geführt und dabei das Freilegen der jeweiligen Elektrodenschicht durch Abscannen der Isolationsschicht realisiert.

Vorzugsweise wird die Laserstrahlung mehrfach über einen Isolationsschichtoberflächenbereich geführt.

Das bedeutet, um eine gewünschte Form eines in der Isolationsschicht durch Abtragen entstehenden Grabens zu erzeugen, kann das Freilegen der Elektrodenschicht durch mehrere Überfahren realisiert werden, die teilweise auch nebeneinander oder übereinander liegen können. Dabei wird die Laserstrahlung so über die Isolationsschichtoberfläche geführt, dass vorzugsweise die Breite des entstehenden Grabens ausreicht, dass die Elektrodenschicht vollständig freigelegt ist.

Ein beispielhafter, als solcher nicht erfindungsgemäßer elektromechanischer Aktor, der insbesondere mit einem oben beschriebenen Herstellungsverfahren hergestellt worden ist, weist ein als Stapel ausgebildetes elektrisches Bauelement auf, das aus einer Mehrzahl auf Anlegen eines elektrischen Feldes reagierenden Werkstoffschichten und aus einer Mehrzahl von Elektrodenschichten gebildet ist. Jede Elektrodenschicht ist zwischen zwei Werkstoffschichten angeordnet, wobei der Stapel an wenigstens einem Umfangsbereich eine Isolationsschicht aufweist. Zum Freilegen wenigstens einer Elektrodenschicht an dem Umfangsbereich des Stapels senkrecht zu einer Längsachse des Stapels ist ein Graben gebildet, der sich vollständig durch die Isolationsschicht eines der Elektrodenschichten benachbarten Isolationsschichtbereiches und in einem Bereich von 10% bis 20% der sich senkrecht zu der Längsachse des Stapels erstreckenden Breite der Werkstoffschichten in Werkstoffschichtbereiche von der Elektrodenschicht benachbarte Werkstoffschichten derart erstreckt, dass die Elektrodenschicht in den Graben hervorsteht.

So ist eine zuverlässige Kontaktierung der Elektrodenschicht von außen durch die Isolationsschicht hindurch gewährleistet.

Vorteilhaft weist der Graben senkrecht zu der Längsachse des Stapels schräg angeordnete Grabenwände auf, wobei sich der Graben von der Isolationsschichtoberfläche in Richtung auf eine Stapelmitte hin verjüngt. Schräg angeordnete Grabenwände haben den Vorteil, dass ein zur Kontaktierung gewählter Leitkleber gut von außen in den Graben hineinfließen kann und so eine vorteilhaft gute Kontaktierung der freigelegten Elektrodenschicht realisiert werden kann.

Der Graben in der Isolationsschicht weist vorzugsweise einen ersten Grabenbereich, in einer entlang der Längsachse des Stapels benachbart zu der Elektrodenschicht angeordneten ersten Werkstoffschicht einen zweiten Grabenbereich, und in einer entlang der Längsachse des Stapels benachbart zu der Elektrodenschicht angeordneten zweiten Werkstoffschicht einen dritten Grabenbereich auf. Die Grabenwände in dem ersten Grabenbereich, in dem zweiten Grabenbereich und in dem dritten Grabenbereich sind senkrecht zu der Längsachse des Stapels schräg angeordnet. Insgesamt weist daher der Graben im Längsschnitt durch den Stapel vorteilhaft eine W-Form auf.

Eine vorteilhafte Ausgestaltung der Erfindung wird nachfolgend anhand der beigefügten Zeichnungen näher erläutert, wobei der Aktor also solcher nicht Gegenstand der Erfindung ist. Darin zeigt:
- Fig. 1: eine perspektivische Darstellung eines elektromechanischen Aktors, der ein als Stapel ausgebildetes elektrisches Bauelement aufweist;
- Fig. 2: eine Längsschnittdarstellung des elektrischen Bauelementes aus Fig. 1, das an zwei sich gegenüberliegenden Umfangsbereichen jeweils eine Isolationsschicht aufweist, wobei ein Laser vorhanden ist, der zum Entfernen der Isolationsschicht vorgesehen ist;
- Fig. 3: eine Längsschnittdarstellung des elektrischen Bauelementes aus Fig. 2 mit in Teilbereichen entfernter Isolationsschicht;
- Fig. 4: eine schematische Darstellung von Schritten eines Herstellungsverfahrens zum Herstellen des elektromechanischen Aktors aus Fig. 1;
- Fig. 5: eine vergrößerte Darstellung eines Teilbereiches des in Fig. 2 dargestellten Bauelementes, wobei das Abtragen der Isolationsschicht durch eine Laserstrahlung dargestellt ist;
- Fig. 6: das als Stapel ausgebildete elektrische Bauelement aus Fig. 3 mit zusätzlich auf die Isolationsschicht aufgebrachter Außenkontaktierung; und
- Fig. 7: einen Teilbereich des elektrischen Bauelements aus Fig. 6, in dem ein durch Abtragen mit dem Laser gemäß Fig. 5 gebildeter Graben in Isolationsschicht und Werkstoffschichten zu sehen ist.

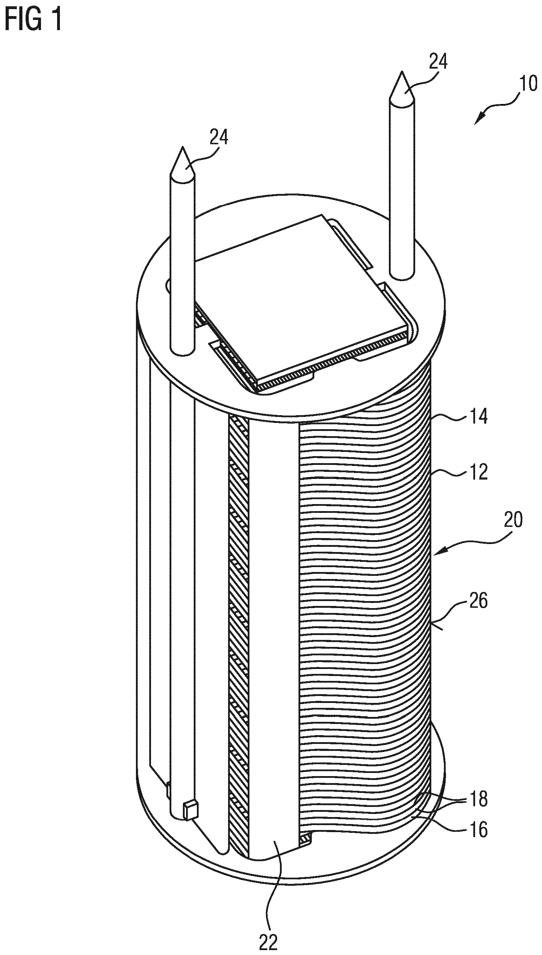

Fig.1 zeigt einen elektromechanischen Aktor 10, der ein elektrisches Bauelement 12 aufweist, das als Stapel 14 ausgebildet ist, wobei eine Mehrzahl von auf Anlegen eines elektrischen Feldes reagierenden Werkstoffschichten 16 und eine Mehrzahl von Elektrodenschichten 18 abwechselnd derart aufeinander gestapelt sind, dass jede Elektrodenschicht 18 zwischen zwei Werkstoffschichten 16 angeordnet ist. Auf einem Umfangsbereich 20 des Stapels 14 ist wenigstens eine Außenkontaktierung in Form einer Außenelektrode 22 aufgebracht, die elektrisch mit einem Kontaktierungspin 24 verbunden ist. Über den Kontaktierungspin 24 kann ein elektrisches Potential an die jeweils kontaktierte Elektrodenschicht 18 weitergeleitet werden. Da jeweils zueinander benachbarte Elektrodenschichten 18 mit unterschiedlichen elektrischen Potentialen beaufschlagt werden, um so ein elektrisches Feld in dem Stapel 14 zu erzeugen, damit die Werkstoffschichten 16 sich in ihrer Länge verändern können, sind zwei Kontaktierungspins 24 vorhanden, über die jeweils ein unterschiedliches Potential an den Stapel 14 herangeführt wird.

In der vorliegenden Ausführungsform in Fig. 1 ist der Stapel 14 als sogenannter vollaktiver Piezostapel ausgebildet, d.h. die Elektrodenschichten 18 erstrecken sich allseitig bis an eine Stapeloberfläche 26. Ein vollaktiver Piezostapel, bei dem die Elektrodenschichten allseitig an den Umfangsbereich 20 des Stapels 14 herangeführt sind, hat den Vorteil, dass bei kleinerer Raumbeanspruchung wenigstens ein gleiches Ausdehnungsverhalten oder sogar noch ein größeres Ausdehnungsverhalten erzielt werden kann, als bei Piezostapeln, die nicht voll aktiv sind, d.h. bei denen die Elektrodenschichten 18 abwechselnd vom Umfangsbereich 20 in den Stapel 14 hinein zurückversetzt angeordnet sind.

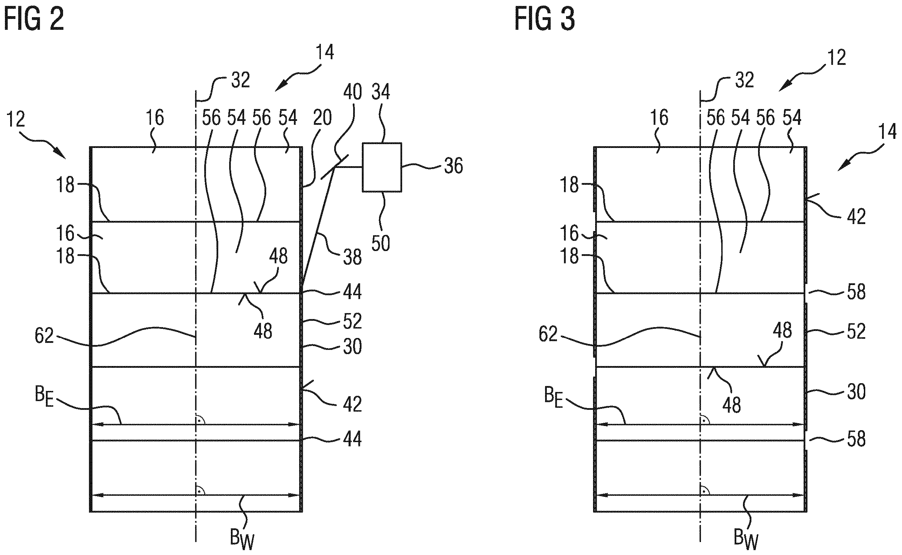

Um einen Überschlag zwischen den über die beiden Kontaktierungspins 24 aufgebrachten unterschiedlichen Potentialen zu vermeiden, wird gewöhnlich auf die Stapeloberfläche 26, zumindest bereichsweise, auf den Umfangsbereich 20 des Stapels 14 eine Isolationsschicht 30 aufgebracht. Ein Stapel 14, der an wenigstens zwei Umfangsbereichen 20 eine solche Isolationsschicht 30 aufweist, ist in Fig. 2 in einer Längsschnittdarstellung entlang einer Längsachse 32 des Stapels 14 in Fig.1 gezeigt.

Um die Elektrodenschichten 18 von außen kontaktieren zu können, ist es nötig, die Isolationsschicht 30 in Teilbereichen, d.h. dort, wo die Elektrodenschicht 18, die jeweils kontaktiert werden soll, an die Stapeloberfläche 26 hervortritt, zu entfernen.

Zum Abtragen der Isolationsschicht 30 in diesen genannten Teilbereichen wird daher vorteilhaft ein Laser 34, insbesondere ein Pikosekunden-Laser 36 verwendet, der eine Laserstrahlung 38 auf die Isolationsschicht 30 aussendet und diese somit abträgt, so dass die darunterliegende Elektrodenschicht 18 freigelegt wird.

Vorteilhaft wird die Laserstrahlung 38 über ein scannendes Verfahren, beispielsweise mit Hilfe eines Galvanoscanners 40, über eine Isolationsschichtoberfläche 42 geführt, so dass die Isolationsschicht 30 bahnweise abgetragen wird.

Nachdem die Isolationsschicht 30 in den vorgesehenen Bereichen abgetragen ist, ist ein Stapel 14 ausgebildet, wie er in Fig. 3 in einer Längsschnittdarstellung entlang der Längsachse 32 gezeigt ist.

Es ist vorteilhaft, wenn bei dem Herstellungsverfahren, das entsprechend Fig. 2 und Fig. 3 durch Abtragen der Isolationsschicht 30 durchgeführt wird, die vollaktiven Eigenschaften des Stapels 14 erhalten bleiben. Dazu ist bevorzugt, dass die Elektrodenschicht 18 möglichst nicht beschädigt wird, wenn die Isolationsschicht 30 abgetragen wird. Gleichzeitig soll jedoch die Isolationsschicht 30 so vollständig abgetragen werden, dass eine gute Kontaktierung der Elektrodenschicht 18, die somit freigelegt wird, erzielt wird. Daher wird nun vorgeschlagen, bei dem Herstellungsverfahren die Parameter, die eine Abtragungsrate der jeweils abzutragenden Materialien bestimmt, so auszuwählen bzw. einzustellen, dass ein Isolationsschichtbereich 44, der der freizulegenden Elektrodenschicht 18 benachbart ist, möglichst vollständig abgetragen wird. Gleichzeitig soll die Abtragungsrate so eingestellt werden, dass auch entlang der Längsachse 32 des Stapels 14 zu der freizulegenden Elektrodenschicht 18 benachbarte Werstoffschichtbereiche 46 im Bereich der Stapeloberfläche 26 abgetragen werden, so dass Stirnseiten 48 der freizulegenden Elektrodenschicht 18, die sich senkrecht zu der Längsachse 32 des Stapels 14 erstrecken, zumindest im Bereich der Stapeloberfläche 26 ebenfalls freigelegt werden. So kann später eine sehr gute Kontaktierung der Elektrodenschicht 18 erzielt werden.

Die Parameter, die die Abtragungsrate des jeweils abzutragenden Materials bestimmen, sind einerseits physikalische Eigenschaften des abzutragenden Materials selbst und andererseits Abtragungsparameter, die in einer entsprechenden Abtragungsvorrichtung 50, wie beispielsweise dem Laser 34, eingestellt werden können.

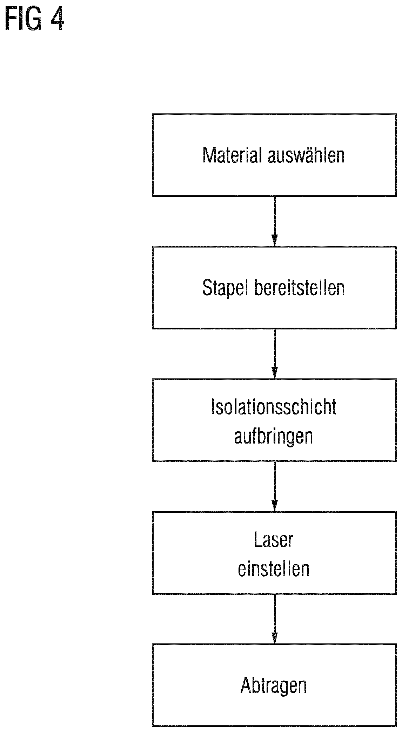

Das erfindungsgemäße Herstellungsverfahren, mit dem der elektromechanische Aktor 10 bzw. das elektrische Bauelement 12 hergestellt werden soll, wird nachfolgend anhand der schematischen Darstellung einzelner Schritte in Fig. 4 beschrieben.

In einem ersten Schritt werden zunächst ein Isolationsschichtmaterial 52, ein Werkstoffschichtmaterial 54 und eine Elektrodenschichtmaterial 56 ausgewählt. Vorteilhaft wird dabei als Isolationsschichtmaterial 52 ein Polyimid, als Werkstoffschichtmaterial 54 eine Piezokeramik und als Elektrodenmaterial 56 ein mit Palladium versetztes Silber ausgewählt.

In einem nächsten Schritt wird der Stapel 14 bereitgestellt, indem das Werkstoffschichtmaterial 54 und das Elektrodenschichtmaterial 56 abwechselnd aufeinander gestapelt werden. Danach wird das Isolationsschichtmaterial 52 auf den Umfangsbereich 20 des derart bereitgestellten Stapels 14 aufgebracht, um so die Isolationsschicht 30 zu bilden. Die Isolationsschicht 30 bedeckt an dem Umfangsbereich 20 sowohl die Elektrodenschichten 18 als auch die Werkstoffschichten 16, die an diesen Umfangsbereich 20 angrenzen.

In einem nächsten Schritt wird dann der Laser 34 mit vorbestimmten Abtragungsparametern eingestellt und werden dann in einem letzten Schritt die Elektrodenschichten 18 unter Zuhilfenahme der Laserstrahlung 38 selektiv abgetragen.

Die Wahl der Laserparameter erfolgt derart, dass eine doppelte Selektivität erreicht wird, d.h. eine Selektivität zwischen Werkstoffschichtmaterial 54, Elektrodenschichtmaterial 56 und Isolationsschichtmaterial 52. Doppelte Selektivität heißt hier, dass die erste Abtragungsrate R_{I} für das Isolationsschichtmaterial 52 wesentlich höher ist als die zweite Abtragungsrate R_{W} für das Werkstoffschichtmaterial, und dass gleichzeitig die zweite Abtragungsrate R_{W} für das Werkstoffschichtmaterial 54 wesentlich höher ist als die dritte Abtragungsrate R_{E} für das Elektrodenschichtmaterial 56. Vorzugsweise werden die Laserparameter so eingestellt, dass die erste Abtragungsrate R_{I} des Isolationsschichtmaterials 52 mindestens fünf mal so groß ist wie die zweite Abtragungsrate R_{W} des Werkstoffschichtmaterials 54, und dass die zweite Abtragungsrate R_{W} des Werkstoffschichtmaterials 54 mindestens fünf mal so groß ist wie die dritte Abtragungsrate R_{E} des Elektrodenschichtmaterials 56.

Ziel ist es, den Isolationsschichtbereich 44 senkrecht zu der Längsachse 32 des Stapels 14 vollständig abzutragen, und dabei die Werkstoffschichtbereiche 46, die direkt benachbart zu der freizulegenden Elektrodenschicht 18 angeordnet sind, ausgehend von einer Stapeloberfläche 26 auf eine Stapelmitte 62 zu in einem Bereich zwischen 10 % und 20 % der sich senkrecht zu der Längsachse 32 des Stapels 14 erstreckenden Breite B_{W} der jeweiligen Werkstoffschicht 16 abzutragen. Gleichzeitig ist es das Ziel, die Elektrodenschicht 18 möglichst gar nicht abzutragen oder maximal in einem Bereich zwischen 0 % und 1 % der sich senkrecht zu der Längsachse 32 des Stapels 14 erstreckenden Breite B_{E} der Elektrodenschicht 18.

Die Parameter des Lasers 34 werden so eingestellt, dass die oben genannte Selektivität über eine entsprechende Leistungsdichte des Lasers 34 eingestellt wird. Die Leistungsdichte ergibt sich dabei beispielsweise aus der Pulsenergie, der Pulsdauer und der Fokusfläche des Lasers 34.

Vorteilhaft wird ein Pikosekunden-Laser 36 verwendet, der eine Pulslänge bzw. Pulsdauer in einem Bereich von 1 ps bis 15 ps aufweist. Dadurch kann eine hohe Leistungsdichte generiert werden, die den vollständigen Abtrag der Isolationsschicht 30 gewährleistet. Die Verwendung eines Femtosekundenlasers würde eine deutlich höhere Leistungsdichte generieren, die dann auch zu einem Abtrag der Elektrodenschicht 18 führen kann, was unerwünscht ist. Vorteilhaft wird die Wellenlänge des Pikosekunden-Lasers 36 so eingestellt, dass chemische Bindungen in der Isolationsschicht 30 aufgelöst werden, beispielsweise eine Wellenlänge von 330 nm bis 345 nm. Eine Pulsenergie der Laserpulse des Lasers 34 beträgt vorteilhaft 1,2 µJ bis 1,6 µJ.

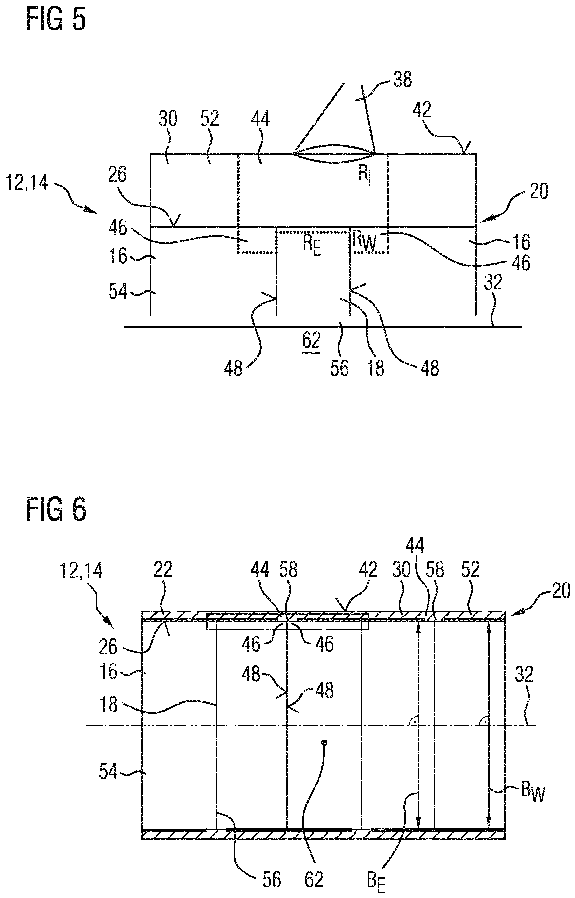

Fig. 5 zeigt einen Ausschnitt aus dem Stapel 14 aus Fig. 2, wobei eine Laserstrahlung 38 auf die Isolationsschichtoberfläche 42 fokussiert ist. Die vorteilhafte Fokusfläche der Laserstrahlung 38 beträgt dabei etwa 20 µm bis 60 µm. Dadurch wird, wie in Fig. 5 durch gestrichelte Linien angedeutet ist, ein Abtrag der Isolationsschicht 30 vollständig erzielt, und die Werkstoffschichten 16, die benachbart von der freizulegenden Elektrodenschicht 18 angeordnet sind, werden nur oberflächlich abgetragen, etwa 10 % bis 20 % ihrer Breite B_{w}.

Nachdem die jeweiligen Elektrodenschichten 18 freigelegt sind, kann dann eine Außenelektrode 22 aufgebracht werden, beispielsweise durch Aufbringen eines Leitsilbers wie in Fig. 6 gezeigt.

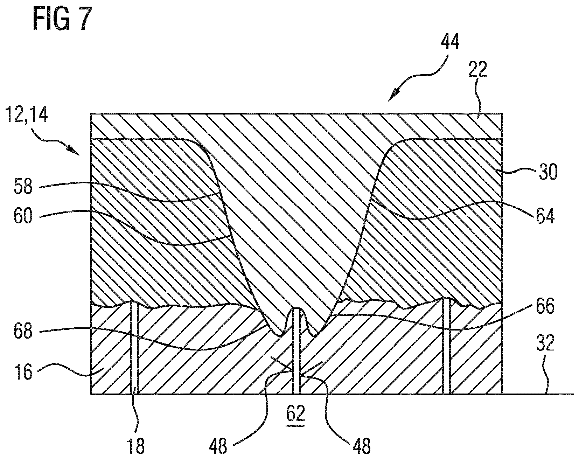

Fig. 7 zeigt einen Ausschnitt aus Fig. 6, bei dem in der Isolationsschicht 30 und den Werkstoffschichten 16, die benachbart zu der mittleren Elektrodenschicht 18 angeordnet sind, ein Graben 58 zu sehen ist, der durch das Freilegen der Elektrodenschicht 18 entstanden ist. Dieser Graben 58 erstreckt sich vollständig durch die Isolationsschicht 30 und weiter noch 10 % bis 20 % entlang der Breite B_{w} der Werkstoffschichten 16, die benachbart zu der freigelegten Elektrodenschicht 18 angeordnet sind. Dadurch steht die Elektrodenschicht 18 in den Graben 58 hervor. Grabenwände 60 des Grabens sind senkrecht zu der Längsachse 32 des Stapels 14 schräg angeordnet. Der Graben 58 verjüngt sich ausgehend von der Isolationsschichtoberfläche 42 in Richtung auf die Stapelmitte 62.

Der Graben 58 weist drei Grabenbereiche auf, nämlich einen ersten Grabenbereich 64 in der Isolationsschicht 30, einen zweiten Grabenbereich 66 in der einen zu der Elektrodenschicht 18 benachbarten Werkstoffschicht 16 und einen entsprechenden dritten Grabenbereich 68 in der anderen zu der freigelegten Elektrodenschicht 18 benachbarten Werkstoffschicht 16. Alle Grabenwände 60 der einzelnen Grabenbereiche 64, 66, 68 sind senkrecht zu der Längsachse 32 schräg angeordnet, so dass ein zur Kontaktierung verwendeter Leitkleber gut in den gesamten Graben 58 einfließen kann und somit eine gute Kontaktierung der freigelegten Elektrodenschichten 18 realisiert werden kann. Insgesamt weist der Graben 58 eine Form entsprechend eines W auf. Diese W-Form wird insbesondere durch die besondere Auswahl der einzelnen Materialien und die Einstellung der Abtragungsparameter des Lasers 34 erzielt, so dass insgesamt eine doppelte Selektivität durch spezielle sich unterscheidende Abtragungsraten R_{I}, R_{W} und R_{E} erzielt wird.

## Patentansprüche

1. Herstellungsverfahren zum Herstellen eines elektromechanischen Aktors (10), aufweisend die Schritte:
a) Bereitstellen eines als Stapel (14) ausgebildeten elektrischen Bauelements (12), das aus einer Mehrzahl von auf Anlegen eines elektrischen Feldes reagierenden Werkstoffschichten (16) und aus einer Mehrzahl von Elektrodenschichten (18) gebildet ist, wobei jede Elektrodenschicht (18) zwischen zwei Werkstoffschichten (16) angeordnet ist;
b) Aufbringen einer Isolationsschicht (30) auf wenigstens einen Umfangsbereich (20) des Stapels (14) derart, dass an dem Umfangsbereich (20) die Elektrodenschichten (18) und die Werkstoffschichten (16) von der Isolationsschicht (30) bedeckt sind;
c) Freilegen wenigstens einer der Elektrodenschichten (18) an dem Umfangsbereich (20) des Stapels (14) durch lokales Abtragen eines der Elektrodenschicht (18) benachbarten Isolationsschichtbereiches (44) und von der Elektrodenschicht (18) entlang einer Längsachse (32) des Stapels (14) benachbarten Werkstoffschichtbereichen (46),
**dadurch gekennzeichnet, dass** ein Isolationsschichtmaterial (52), ein Werkstoffschichtmaterial (54) und ein Elektrodenschichtmaterial (56) so ausgewählt werden, und wobei Abtragungsparameter einer Abtragungsvorrichtung (50) zum Abtragen des Isolationsschichtbereiches (44) und der Werkstoffschichtbereiche (46) so eingestellt werden, dass eine erste Abtragungsrate (R_{I}) des Isolationsschichtmaterials (52) wesentlich größer ist als eine zweite Abtragungsrate (R_{W}) des Werkstoffschichtmaterials (54), und dass die zweite Abtragungsrate (R_{W}) des Werkstoffschichtmaterials (54) wesentlich größer ist als eine dritte Abtragungsrate (R_{E}) des Elektrodenschichtmaterials (56).

2. Herstellungsverfahren nach Anspruch 1,
**dadurch gekennzeichnet, dass** das Isolationsschichtmaterial (52), das Werkstoffschichtmaterial (54) und das Elektrodenschichtmaterial (56) so ausgewählt werden und die Abtragungsparameter der Abtragungsvorrichtung (50) so eingestellt werden, dass der Isolationsschichtbereich (44) senkrecht zu der Längsachse (32) des Stapels (14) vollständig abgetragen wird und/oder dass die Werkstoffschichtbereiche (46) senkrecht zu der Längsachse (32) des Stapels (14) zwischen 10 % und 20 % der sich senkrecht zu der Längsachse (32) des Stapels (14) erstreckenden Breite (B_{W}) der Werkstoffschichten (16) abgetragen werden und/oder dass die Elektrodenschicht (18) senkrecht zu der Längsachse (32) des Stapels (14) zwischen 0 % und 1 % der sich senkrecht zu der Längsachse (32) des Stapels (14) erstreckenden Breite (B_{E}) der Elektrodenschicht (18) abgetragen wird.

3. Herstellungsverfahren nach einem der Ansprüche 1 oder 2,
**dadurch gekennzeichnet, dass** das Isolationsschichtmaterial (52), das Werkstoffschichtmaterial (54) und das Elektrodenschichtmaterial (56) so ausgewählt werden und die Abtragungsparameter der Abtragungsvorrichtung (50) so eingestellt werden, dass die erste Abtragungsrate (R_{I}) wenigstens fünfmal größer ist als die zweite Abtragungsrate (R_{W}) und/oder dass die zweite Abtragungsrate (R_{W}) wenigstens fünfmal größer ist als die dritte Abtragungsrate (R_{E}).

4. Herstellungsverfahren nach einem der Ansprüche 1 bis 3,
**dadurch gekennzeichnet, dass** als Isolationsschichtmaterial (52) ein Polyimid, als Werkstoffschichtmaterial (54) eine Piezokeramik und als Elektrodenschichtmaterial (56) mit Palladium versetztes Silber ausgewählt wird.

5. Herstellungsverfahren nach einem der Ansprüche 1 bis 4,
**dadurch gekennzeichnet, dass** als Abtragungsvorrichtung (50) ein Laser (34), insbesondere ein Pikosekunden-Laser (36) mit einer Pulslänge zwischen 1 ps und 15 ps, verwendet wird.

6. Herstellungsverfahren nach Anspruch 5,
**dadurch gekennzeichnet, dass** eine Wellenlänge des Lasers (34) so eingestellt wird, dass durch Beaufschlagen der Isolationsschicht (30) mit einer Laserstrahlung (38) des Lasers (34) chemische Bindungen in der Isolationsschicht (30) gelöst werden, wobei insbesondere eine Wellenlänge von 330 nm bis 345 nm eingestellt wird und/oder dass eine Pulsenergie von Laserpulsen des Lasers (34) in einem Bereich zwischen 1,2 µJ und 1,6 µJ und/oder eine Fokusfläche einer Laserstrahlung (38) des Lasers (34) in einem Bereich von 20 µm bis 60 µm eingestellt wird.

7. Herstellungsverfahren nach einem der Ansprüche 5 oder 6,
**dadurch gekennzeichnet, dass** eine Laserstrahlung (38) des Lasers (34), insbesondere mit Hilfe eines Galvanoscanners (40), über eine Isolationsschichtoberfläche (42) geführt wird, wobei die Laserstrahlung (38) vorteilhaft mehrfach über einen Isolationsschichtoberflächenbereich (42) geführt wird.

## Claims

1. Production method for producing an electromechanical actuator (10), comprising the steps of:
a) providing an electrical component (12) formed as a stack (14), formed by a plurality of material layers (16) that react to application of an electrical field and a plurality of electrode layers (18), each electrode layer (18) being arranged between two material layers (16);
b) applying an insulating layer (30) to at least one peripheral region (20) of the stack (14) in such a way that at the peripheral region (20) the electrode layers (18) and the material layers (16) are covered by the insulating layer (30);
c) exposing at least one of the electrode layers (18) at the peripheral region (20) of the stack (14) by locally removing an insulating layer region (44) adjacent to the electrode layer (18) and material layer regions (46) adjacent to the electrode layer (18) along a longitudinal axis (32) of the stack (14),
**characterized in that**
an insulating layer material (52), a material layer material (54) and an electrode layer material (56) are so selected, and wherein removal parameters of a removing device (50) for removing the insulating layer region (44) and the material layer regions (46) are so set that a first removal rate (R_{I}) of the insulating layer material (52) is much greater than a second removal rate (R_{W}) of the material layer material (54), and that the second removal rate (R_{W}) of the material layer material (54) is much greater than a third removal rate (R_{E}) of the electrode layer material (56).

2. Production method according to Claim 1,
**characterized in that** the insulating layer material (52), the material layer material (54) and the electrode layer material (56) are so selected and the removal parameters of the removing device (50) are so set that the insulating layer region (44) perpendicular to the longitudinal axis (32) of the stack (14) is removed completely and/or that the material layer regions (46) perpendicular to the longitudinal axis (32) of the stack (14) between 10% and 20% of the width (B_{W}) of the material layers (16) extending perpendicularly to the longitudinal axis (32) of the stack (14) are removed and/or that the electrode layer (18) perpendicular to the longitudinal axis (32) of the stack (14) between 0% and 1% of the width (B_{E}) of the electrode layer (18) extending perpendicularly to the longitudinal axis (32) of the stack (14) is removed.

3. Production method according to either of Claims 1 and 2,
**characterized in that** the insulating layer material (52), the material layer material (54) and the electrode layer material (56) are so selected and the removal parameters of the removing device (50) are so set that the first removal rate (R_{I}) is at least five times greater than the second removal rate (R_{W}) and/or that the second removal rate (R_{W}) is at least five times greater than the third removal rate (R_{E}).

4. Production method according to one of Claims 1 to 3,
**characterized in that** a polyimide is selected as the insulating layer material (52), a piezoceramic is selected as the material layer material (54) and silver mixed with palladium is selected as the electrode layer material (56).

5. Production method according to one of Claims 1 to 4,
**characterized in that** a laser (34), in particular a picosecond laser (36), with a pulse length of between 1 ps and 15 ps, is used as the removing device (50).

6. Production method according to Claim 5,
**characterized in that** a wavelength of the laser (34) is so set that chemical bonds in the insulating layer (30) are broken by subjecting the insulating layer (30) to a laser radiation (38) of the laser (34), in particular a wavelength of 330 nm to 345 nm being set, and/or **in that** a pulse energy of laser pulses of the laser (34) is set in a range between 1.2 µJ and 1.6 µJ and/or a focal area of a laser radiation (38) of the laser (34) is set in a range of 20 µm to 60 µm.

7. Production method according to either of Claims 5 and 6,
**characterized in that** a laser radiation (38) of the laser (34) is passed over an insulating layer surface (42), in particular with the aid of a galvano scanner (40), the laser radiation (38) advantageously being passed a number of times over an insulating layer surface region (42).

## Revendications

1. Procédé de fabrication destiné à la fabrication d'un actionneur électromécanique (10), comprenant les étapes consistant à :
a) prévoir un composant électrique (12) réalisé sous la forme d'un empilement (14), qui est formé d'une pluralité de couches de matériau (16) réagissant à l'application d'un champ électrique, et d'une pluralité de couches d'électrode (18), dans lequel chaque couche d'électrode (18) est disposée entre deux couches de matériau (16) ;
b) appliquer une couche isolante (30) sur au moins une zone périphérique (20) de l'empilement (14) de manière à ce qu'à la zone périphérique (20) les couches d'électrode (18) et les couches de matériau (16) soient recouvertes par la couche isolante (30) ;
c) exposer au moins l'une des couches d'électrode (18) dans la zone périphérique (20) de l'empilement (14) par enlèvement local d'une zone de couche isolante (44) adjacente à la couche d'électrode (18) et de zones de couche de matériau (46) adjacentes à la couche d'électrode (18) le long d'un axe longitudinal (32) de l'empilement (14),
**caractérisé en ce qu'**un matériau de couche isolante (52), un matériau de couche de matériau (54) et un matériau de couche d'électrode (56) sont sélectionnés et des paramètres d'enlèvement d'un dispositif d'enlèvement (50) destiné à enlever la zone de couche isolante (44) et les zones de couche de matériau (46) sont fixés de manière à ce qu'un premier taux d'enlèvement (R_{I}) du matériau de couche isolante (52) soit sensiblement supérieur à un deuxième taux d'enlèvement (R_{W}) du matériau de couche de matériau (54), et à ce que le deuxième taux (R_{W}) d'enlèvement du matériau de couche de matériau (54) soit sensiblement supérieur à un troisième taux d'enlèvement (R_{E}) du matériau de couche d'électrode (56).

2. Procédé de fabrication selon la revendication 1, **caractérisé en ce que** le matériau de couche isolante (52), le matériau de couche de matériau (54) et le matériau de couche d'électrode (56) sont sélectionnés et les paramètres d'enlèvement du dispositif d'enlèvement (50) sont fixés de manière à ce que la zone de couche isolante (44) soit complètement enlevée perpendiculairement à l'axe longitudinal (32) de l'empilement (14) et/ou à ce que les zones de couche de matériau (46) soient enlevées perpendiculairement à l'axe longitudinal (32) de l'empilement (14) sur 10% à 20% de la largeur (B_{W}) des couches de matériau (16) s'étendant perpendiculairement à l'axe longitudinal (32) de l'empilement (14) et/ou à ce que la couche d'électrode (18) soit enlevée perpendiculairement à l'axe longitudinal (32) de l'empilement (14) sur 0% à 1% de la largeur (B_{E}) de la couche d'électrode (18) s'étendant perpendiculairement à l'axe longitudinal (32) de l'empilement (14).

3. Procédé de fabrication selon l'une des revendications 1 ou 2, **caractérisé en ce que** le matériau de couche isolante (52), le matériau de couche de matériau (54) et le matériau de couche d'électrode (56) sont sélectionnés et les paramètres d'enlèvement du dispositif d'enlèvement (50) sont fixés de manière à ce que le premier taux d'enlèvement (R_{I}) soit au moins cinq fois supérieur au deuxième taux d'enlèvement (R_{W}) et/ou à ce que le deuxième taux d'enlèvement (R_{W}) soit au moins cinq fois supérieur au troisième taux d'enlèvement (R_{E}).

4. Procédé de fabrication selon l'une des revendications 1 à 3, **caractérisé en ce qu'**un polyimide est sélectionné en tant que matériau de couche isolante (52), une piézocéramique est sélectionnée en tant que matériau de couche de matériau (54) et de l'argent additionné de palladium est sélectionné en tant que matériau de couche d'électrode (56).

5. Procédé de fabrication selon l'une des revendications 1 à 4, **caractérisé en ce qu'**un laser (34), notamment un laser picoseconde (36) ayant une longueur d'impulsion comprise entre 1 ps et 15 ps, est utilisé en tant que dispositif d'enlèvement (50) .

6. Procédé de fabrication selon la revendication 5, **caractérisé en ce qu'**une longueur d'onde du laser (34) est fixée de manière à ce que des liaisons chimiques présentes dans la couche isolante (30) soient rompues par exposition de la couche isolante (30) au rayonnement laser (38) du laser (34), dans lequel une longueur d'onde de 330 nm à 345 nm est notamment fixée et/ou **en ce qu'**une énergie d'impulsion des impulsions laser du laser (34) est fixée dans une plage comprise entre 1,2 µJ et 1,6 µJ et/ou **en ce qu'**une zone de focalisation d'un rayonnement laser (38) du laser (34) est fixée dans une plage comprise entre 20 µm et 60 µm.

7. Procédé de fabrication selon l'une des revendications 5 ou 6, **caractérisé en ce qu'**un rayonnement laser (38) du laser (34) est guidé par l'intermédiaire d'une surface de couche isolante (42), notamment à l'aide d'un scanner galvanométrique (40), dans lequel le rayonnement laser (38) est avantageusement guidé plusieurs fois par l'intermédiaire d'une surface de couche isolante (42).
